# EUROPÄISCHE PATENTSCHRIFT

(11) **EP 0 565 012 B1**
(45) Veröffentlichungstag und Bekanntmachung des Hinweises auf die Patenterteilung: **02.07.1997**
(21) Anmeldenummer: 93105564.4
(22) Anmeldetag: 03.04.1993
(51) Int. Cl.: H01S 3/085, H01S 3/103

(54) **Durchstimmbarer Halbeiterlaser**
Tunable semi-conductor laser
Laser à semi-conducteur accordable

(30) Priorität: 10.04.1992 DE 4212152
(43) Veröffentlichungstag der Anmeldung: 13.10.1993
(73) Patentinhaber: Alcatel SEL Aktiengesellschaft, D-70435 Stuttgart (DE); ALCATEL N.V., NL-1077 XX Amsterdam (NL)
(72) Erfinder: Dütting, Kaspar, W-7000 Stuttgart 31 (DE); Hildebrand, Olaf Dr., W-7000 Stuttgart 61 (DE); Baums, Dieter, Dr., W-7140 Ludwigsburg (DE); Idler, Wilfried, W-7145 Markgröningen (DE); Schilling, Michael, W-7000 Stuttgart 31 (DE); Wünstel, Klaus, Dr., W-7141 Schwieberdingen (DE)
(74) Vertreter: Pechhold, Eberhard, Dipl.-Phys.

(56) Entgegenhaltungen:
- EP-A- 0 162 660
- EP-A- 0 418 705
- EP-A- 0 516 044
- WO-A-84/03399
- IEEE JOURNAL OF QUANTUM ELECTRONICS Bd. 27, Nr. 6, Juni 1991, NEW YORK, USA
- Seiten 1616 - 1624 , XP229862 M. SCHILLING ET AL. 'Integrated Interferometric Injection Laser: Novel Fast and Broad-Band Tunable Monolithic Light Source'
- ELECTRONICS LETTERS Bd. 19, Nr. 22, Oktober 1983, LONDON, GB Seiten 926 - 927 H.A. FATAH ET AL. 'Electrical Tuning or Semiconductor Interferometric Laser'
- APPLIED PHYSICS LETTERS Bd. 41, Nr. 2, Juli 1982, NEW YORK, USA Seiten 112 - 114 H.A. ISMAIL 'Semiconductor Interferometric Laser'

## Beschreibung

### Beschreibung für folgende Vertragsstaaten : DE, GB, FR

Die Erfindung betrifft ein Verfahren zum Betrieb eines interferometrischen Halbleiterlasers nach dem Oberbegriff des Patentanspruchs 1.

Ein Verfahren zum Betrieb eines interferometrischen Halbleiterlasers ist z.B. aus einem Aufsatz von M. Schilling et al mit dem Titel: "Integrated Interferometric Injection Laser: Novel Fast and Broad-Band Tunable Monolithic Light Source" in IEEE Journal of Quantum Electronics, Vol. 27, No. 6, June 1991, pp 1616-1622 bekannt. Es wird dort im Zusammenhang mit einnem Halbleiterlaser, der in der einfachsten Ausführung wegen seiner typischen, einem Y ähnlichen Form, auch Y-Laser, genauer YCC-I³-Laser, genannt wird, beschrieben.

Der YCC-I³-Laser weist zwei miteinander gekoppelte Resonatorstrecken auf, welche sich, ausgehend von der Endfläche der Wurzel des Y bis zu den Spiegel-Endflächen der beiden Arme des Y erstrecken. In beiden Resonatoren können sich Fabry-Perot-Moden ausbilden, die, da die Wellenlänge im Vergleich zur Resonatorlänge meist klein ist, sehr dicht liegen. Welche Moden anschwingen, hängt zum einen von den Gewinnkurven des Lasermaterials der aktiven Segmente ab, zum anderen von dem den aktiven Segmenten der Resonatoren zugeführten Strom, der über eine Änderung des Brechungsindex in den strombeeinflußten Segmenten eine Verschiebung der Wellenlängen der Fabry-Perot Moden in den Resonatoren bewirkt. Hierbei wird durch eine Stromänderung in einem gemeinsamen aktiven Segment eine Verschiebung in allen dieses Segment enthaltenden Resonatoren, durch eine Stromänderung in einem nur einem Resonator angehörenden aktiven Segment eine Verschiebung der Wellenlängen der Fabry-Perot-Moden dieses Resonators gegenüber den Wellenlängen der Fabry-Perot-Moden der anderen Resonatoren bewirkt.

Eine Selektion einer einzelnen Fabry-Perot-Mode vorgegebener Wellenlänge bei ausreichender Seitenmoden-Unterdrückung ist deshalb schwierig, weil einerseits, bei Verwendung der flach ausgebildeten Gewinnkurve des Lasermaterials zur Modenselektion, der Gewinnvorsprung einer Fabry-Perot-Mode gegenüber den dicht benachbarten Seitenmoden klein ist und die Auswahl einer Mode gegenüber ihren Nachbarmoden deshalb die exakte Überlagerung der Gewinnkurvenmaxima aller aktiven Segmente erfordert, und weil andererseits, bei Ausnutzung der oben beschriebenen Verschiebung der Fabry-Perot-Modenkämme zweier miteinander gekoppelter Resonatoren (sogenannte Supermoden-Selektion) kleinste Stromänderungen große Wellenlängensprünge verursachen können, was das System schwer beherrschbar macht. Ein Durchstimmen eines in dem o.g. Aufsatz beschriebenen Lasers ist deshalb in der Regel nicht nach einem einfachen Schema möglich, sondern erfordert für jede Wellenlänge sehr exakte, unterschiedliche Einstellungen der verschiedenen Ströme in den aktiven Segmenten. Diese Stromeinstellungen müssen durch Versuche ermittelt und abgespeichert werden.

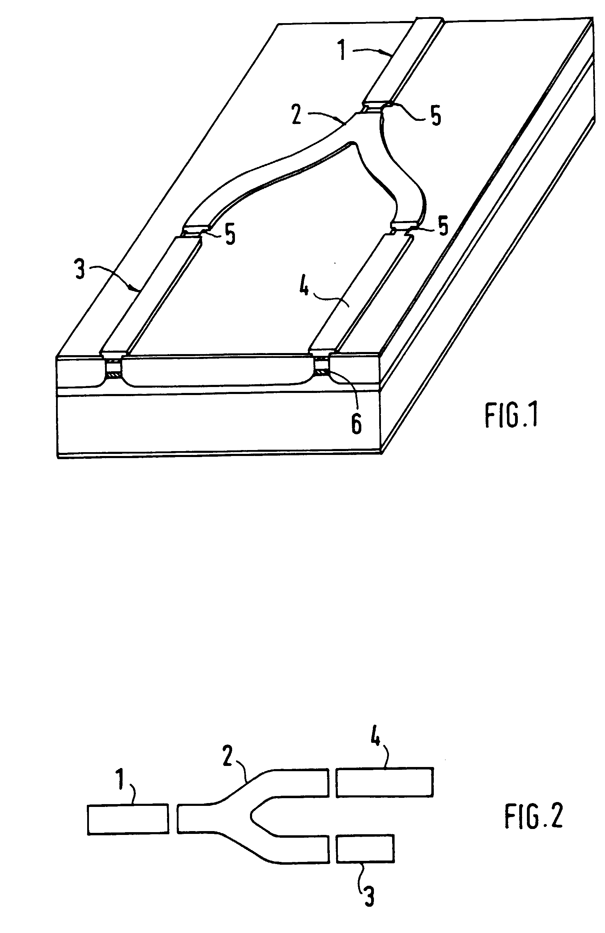

Aus der nach dem Anmeldetag der Ursprungsanmeldung veröffentlichten Europäischen Patentanmeldung 0 516 044 A3 ist eine abstimmbare Laserdiode bekannt (siehe dort Fig. 1) welche eine gerade Kavität mit einem Seitenabzweig besitzt, so daß sich zwei optische Wellenzüge mit unterschiedlichen Längen ausbilden können und zwar einer zwischen den Enden der geraden Kavität und der andere zwischen einem Ende der geraden Kavität und dem Ende des Seitenabzweiges. Von drei aktiven Bereichen befinden sich einer im unverzweigten, von beiden Wellenzügen durchsetzten Teil der geraden Kavität, einer in dem Teil der geraden Kavität, der, jenseits des Abzweigpunktes gelegen, von dem in den Seitenabzweig hinein verlaufenden Wellenzug nicht durchsetzt wird, und einer im Seitenabzweig. Der von beiden Wellenzügen durchsetzte aktive Bereich wird als optischer Verstärker betrieben, in den beiden anderen Bereichen wird der Brechungsindex des das Licht führenden Materials verändert. Der eigentliche Verzweigungsbereich ist nicht aktiv. Wie aus der Beschreibung der Fig. 1 bis 5 der o.g. europäischen Patentanmeldung hervorgeht, bereitet auch diese mit Kavitäten unterchiedlicher optischer Länge ausgebildete abstimmbare Laserdiode Probleme um sie in einem stabilen Betriebszustand zu halten. Dies hat dort letztlich zu der in Fig. 7 der o.g. Europäischen Patentanmeldung wiedergegebenen symmetrischen Lösung mit beidseitig zusammengeführten Kavitäten geführt.

Der Erfindung liegt die Aufgabe zugrunde, ein Verfahren zum Betrieb eines Halbleiterlasers gemäß der Präambel von Anspruch 1 anzugeben, das hinsichtlich einer Kontrollierbaren Wellenlängeneinstellung, hinsichtlich der Zahl der zum Durchstimmen zu verändernden Ströme und hinsichtlich der beim Verändern dieser Ströme geforderten Toleranzen verbessert ist.

Diese Aufgabe wird durch die im Patentanspruch 1 angegebenen Merkmale gelöst.

Durch die stark unterschiedlich ausgelegten optischen Längen zweier miteinander gekoppelten Resonatoren entsteht innerhalb des Halbleiterlasers ein interferometrisches System, das die Eigenschaften eines Mach-Zehnder-Filters besitzt, wie es z.B. zur Untersuchung der Linienbreite und des Rauschens bei Multimode-Lasern bekannt ist.

Das Mach-Zehnder-Filter moduliert hier die flache Gewinnkurve des Lasermaterials in der Art, daß stärker gekrümmte Bereiche entstehen, innerhalb derer benachbarte Fabry-Perot-Moden größere Gewinnunterschiede aufweisen und damit leichter einzeln selektiert werden können. Die Lage der durch die Mach-Zehnder-Filterwirkung erzeugten Gewinn-Maxima auf der Wellenlängen-Achse ist dabei unter Anwendung des Verfahrens nach der Erfindung wesentlich genauer und einfacher einzustellen als die des Maximums mehrerer überlagerter Gewinnkurven der einzelnen Segmente.

Kreuzförmige Laser mit unterschiedlich ausgelegten Längen der miteinander gekoppelten Resonatoren sind aus EP0418705A3 bekannt.

Durch die Benutzung der Mach-Zehnder-Gewinnmaxima als zusätzliches Selektionsmittel wird es z.B. möglich, Halbleiterlaser für ganz bestimmte Anwendungen herzustellen und anwendungsbezogen einzustellen.

So läßt sich durch eine entsprechende Wahl der Differenz der optischen Weglängen zweier Resonatoren der Wellenlängenabstand zwischen benachbarten Mach-Zehnder-Gewinnmaxima und damit auch deren Krümmung bereits bei der Laserherstellung voreinstellen.

Eine genaue Endeinstellung kann durch Variation des Verhältnisses der Ströme durch die mindestens teilweise unterschiedlichen Resonatoren angehörigen Segmente vorgenommen werden.

Ausgestaltungen des Verfahrens nach der Erfindung sind in den Unteransprüchen 2 bis 5 angegeben.

So sieht Patentanspruch 2 vor, das Verhältnis der Ströme in zwei unterschiedlichen Resonatoren angehörenden Segmenten unter Konstanthaltung des Gesamtstromes zu variieren. Damit kann die Lage eines durch Interferenz des in zwei Resonatoren mit unterschiedlichen optischen Weglängen entstehenden Lichtes erzeugten Mach-Zehnder-Gewinnmaximums - das dem Minimum einer Mach-Zehnder-Verlustkurve entspricht - auf der Wellenlängenachse mittels einer einfachen Stromumstellung eingestellt und auf diese Weise eine einzelne Fabry-Perot-Mode aus einer Reihe einander benachbarter Fabry-Perot-Moden zum Anschwingen gebracht werden. Indem der Gesamtstrom des Lasers konstant gehalten wird, verändern sich die Lage des Gewinnmaximums des Lasermaterials und die Wellenlängen möglicher Fabry-Perot-Moden nicht wesentlich und das absolute Mach-Zehnder-Gewinnmaximum kann zur Selektion einzelner Fabry-Perot-Moden über den Fabry-Perot-Modenkamm hinweggeschoben werden. Das Stromverhältnis kann z.B. mittels eines Potentiometers eingestellt werden, dessen Endanschlüsse mit den Lasersegmenten und dessen Abgriff mit einer Konstantstromquelle verbunden sind.

Eine im Patentanspruch 3 beschriebene Betriebsweise ermöglicht das Schieben der Lasermaterial-Gewinnkurve über die Wellenlängenachse und damit, über die Anwahl unterschiedlicher Mach-Zehnder-Gewinnmaxima, die Auswahl bestimmter Wellenlängenbereiche. Es kann so, gemäß Patentanspruch 4, am Ende eines zunächst angewählten Wellenlängenbereichs auf einen Nachbar-Wellenlängenbereich umgeschaltet und damit der Durchstimmbereich des Lasers erheblich erweitert werden. Die Ansteuerung des Lasers bleibt dabei einfach. In gleicher Weise können, unter Konstanthaltung des Verhältnisses der in unterschiedlichen Resonatoren angehörenden Segmenten fließenden Ströme, vorgegebene, in Zentren verschiedener Mach-Zehnder-Gewinnmaxima liegende Fabry-Perot-Moden mit großer Strom-Toleranz, nur durch Variation des über ein oder mehrere gemeinsame Segmente fließenden Gesamtstromes angewählt werden. Ein auf diese Weise betriebener Laser nach der Erfindung eignet sich insbesondere zur optischen Kanalumschaltung in nachrichtentechnischen Anwendungen.

Mit einer Ausgestaltung nach Anspruch 5 kann eine Selektion einzelner Fabry-Perot-Moden mit besonders guter Seitenmoden-Unterdrückung ausgeführt werden.

Anhand mehrerer Figuren sollen nun ein Beispiel zum Stand der Technik und Ausführungsbeispiele des Verfahrens nach der Erfindung ausführlich beschrieben und seine Arbeitsweise erklärt werden.
- Fig. 1: zeigt einen sogenannten Y-Laser nach dem Stand der Technik,
- Fig. 2: zeigt die Anordnung der Segmente bei einem Y-Laser nach der Erfindung,
- Fig. 3: zeigt eine Folge von Mach-Zehnder-Verlustkurven bei unterschiedlich langen, verschiedenen Resonatorstrecken zugeordneten Segmenten,
- Fig. 4: zeigt Durchstimmbereiche des Halbleiterlasers nach der Erfindung,
- Fig. 5: zeigt ein unter Verwendung eines Biprismas und Strahablenkspiegeln aufgebautes zentrales Segment.

Fig. 1 zeigt einen monolithisch aufgebauten Y-Laser nach dem Stand der Technik. Der vertikale Schichtenaufbau dieses Lasers ist entlang der gesamten Y-förmigen Struktur der Laser-Kavität gleich und kann z.B. dem im eingangs genannten Aufsatz, in Fig. 1 und der zugehörigen Beschreibung beschiebenen Aufbau entsprechen. Eine laseraktive Schicht 6 erstreckt sich ohne Unterbrechung entlang der gesamten Y-förmigen, an ihrer Oberfläche durch eine Metallschicht abgedeckten Strucktur. Diese Metallschicht ist an bestimmten Stellen 5 elektrisch aufgetrennt. Die voneinander getrennten Teile der Metallschicht bestimmen die Längen von insgesamt 4 einzeln ansteuerbaren Lasersegmenten 1 bis 4. In dem dargestellten Y-Laser können sich im wesentlichen zwei Resonatoren ausbilden, die jeweils von der reflektierenden Endfläche an der Wurzel der Y-förmigen Struktur zu der ebenfalls reflektierenden Endfläche eines der Arme reichen. In geringerem Maße kann sich auch in einem sich von der Wurzel zur Verzweigung erstreckenden Teilstück der Y-Struktur eine sogenannte Zwickel-Mode ausbilden. Als gemeinsame Segmente beider Resonatorstrecken sind somit das Wurzelsegment 1 und das den Strahlteiler enthaltende Segment 2 anzusehen. Die verbleibenden Segmente 3 und 4 beeinflussen jeweils einen der Resonatoren. Die Stromzuführung zu den Segmenten erfolgt über in der Fig. nicht dargestellte, direkte Kontaktierung der Metallschicht.

Fig. 2 zeigt schematisch die Anordnung der Segmente bei einem Halbleiterlaser nach der Erfindung. Hier ist das Segment 3 wesentlich kürzer als das Segment 4 ausgeführt. Dies führt zu stark unterschiedlichen Längen der miteinander gekoppelten Resonatoren. Der dargestellte Laser verhält sich deshalb wie ein Mach-Zehnder-Filter und moduliert die flache Gewinnkurve des Lasermaterials mit einer Folge wesentlich schärfer als diese gekrümmter Mach-Zehnder-Gewinnkurven.

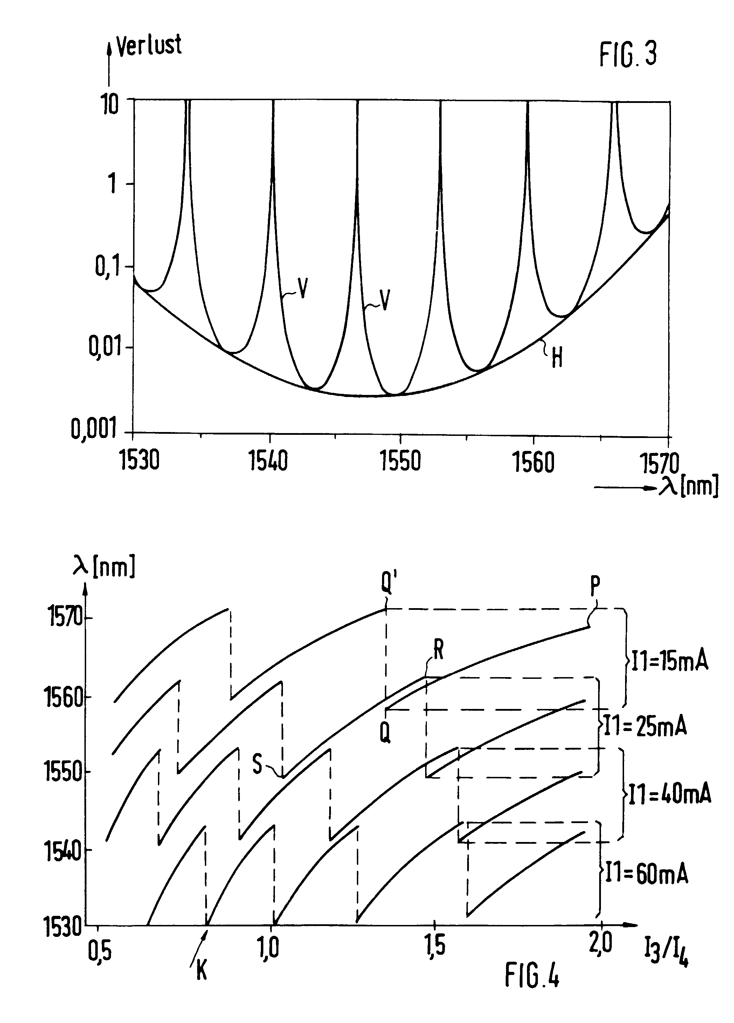

Fig. 3 zeigt den genannten Gewinnkurven entsprechende Verlustkurven V eines unterschiedliche Resonatoren aufweisenden Halbleiterlasers. Es ist hier der Verlust über der Wellenlänge für einen vorgegebenen festen Längenunterschied der Resonatoren aufgetragen. Bei Erhöhung der Segmentströme über einen für den Laserbetrieb notwendigen Mindestwert hinaus werden solche Fabry-Perot-Moden anschwingen, deren Wellenlängen an Stellen liegen, an denen die Verluste am niedrigsten (der Gewinn am höchsten) sind. Nachdem die Mach-Zehnder-Verlustkurven im Bereich ihrer Minima wesentlich stärker gekrümmt sind als ihre Einhüllende H, die Verlustkurve des Lasermaterials, ist hier eine wesentlich höhere Selektivität bei der Auswahl einzelner Fabry-Perot-Moden gegeben und eine viel bessere Seitenmodenunterdrückung möglich als dies die flache Verlustkurve des Lasermaterials zulassen würde.

Zur Auswahl einer Fabry-Perot-Mode wird z.B. das Verhältnis der Ströme in den beiden nicht gemeinsamen Segmenten der beiden interferierenden Resonatorstrecken variiert. Um eine Verschiebung der Verlustkurve des Lasermaterials, der Einhüllenden der Mach-Zehnder-Verlustkurven zu vermeiden, wird dabei der Gesamtstrom konstant gehalten. Damit verschieben sich die Minima der Mach-Zehnder-Verlustkurven V in ihrer Wellenlänge entlang der Einhüllenden H und es schwingt jeweils die Fabry-Perot-Mode an, die im Bereich des tiefsten Minimums aller Mach-Zehnder-Verlustkurven liegt. Wegen der zu beiden Seiten ihrer Minima steil ansteigenden Werte der Mach-Zehnder-Verlustkurven können nah benachbarte Fabry-Perot-Moden nicht gleichzeitig anschwingen. Eine Fabry-Perot-Mode im Bereich der nächsten Mach-Zehnder-Verlustkurve schwingt erst an, wenn die zuvor zur Modenauswahl benutzte Verlustkurve V so weit entlang der Hüllkurve H zu höheren Verlustwerten hin verschoben wurde, daß das Minimum der nächsten Mach-Zehnder-Verlustkurve tiefer zu liegen kommt als das der zuvor benutzten Verlustkurve und deshalb einen geringeren Verlust aufweist. Es springt dann eine Fabry-Perot-Mode mit stark unterschiedlicher Wellenlänge im Bereich dieser nächsten Mach-Zehnder-Verlustkurve an. Immerhin läßt sich aber allein durch Ändern des Verhältnisses der in verschiedenen Resonatoren angehörenden Segmenten fließenden Ströme die Anwahl einzelner benachbarter Fabry-Perot-Moden bei guter Seitenmoden-Unterdrückung in einem Wellenlängenbereich, der dem Abstand zweier Mach-Zehnder-Verlustminima voneinander entspricht, vornehmen.

Da der Abstand der Mach-Zehnder-Verlustminima durch die Differenz der Resonatorlängen bestimmt ist und damit nahezu frei gewählt werden kann, kann der Durchstimmbereich enger oder breiter gewählt und so an die gewünschten Arbeitsbedingungen angepaßt werden. Wie breit der Durchstimmbereich eingestellt werden kann, hängt vom Abstand der Fabry-Perot-Moden und von der geforderten wirksamen Seitenmoden-Unterdrückung ab, welche bei ausschließlicher Variation des o.g. Stromverhältnisses bei Konstanthaltung des Gesamtstromes mit zunehmender Breite des Durchstimmbereiches schlechter wird.

Es gibt jedoch eine Möglichkeit, eine Verbreiterung des Durchstimmbereiches zu erreichen, ohne eine Verschlechterung der Seitenmoden-Unterdrückung in Kauf zu nehmen. Dies wird durch eine Änderung des Gesamtstromes aller Laser-Segmente unter Beibehaltung des eingestellten o.g. Stromverhältnisses erreicht. Eine Gesamtstromänderung, die am einfachsten durch eine Stromänderung in einem beiden Resonatoren gemeinsam angehörenden Lasersegment erreicht wird, verschiebt die Verlustkurve des Lasermaterials, also die Hüllkurve H der Mach-Zehnder-Verlustkurven in ihrer Wellenlänge. Wird nun die Hüllkurve durch Änderung des Gesamtstromes mit der zur Modenauswahl benutzten, durch Änderung des o.g. Stromverhältnisses verschobenen Mach-Zehnder-Verlustkurve mitverschoben, so läßt sich der Durchstimmbereich bei unverändert guter Seitenmoden-Unterdrückung wesentlich verbreitern.

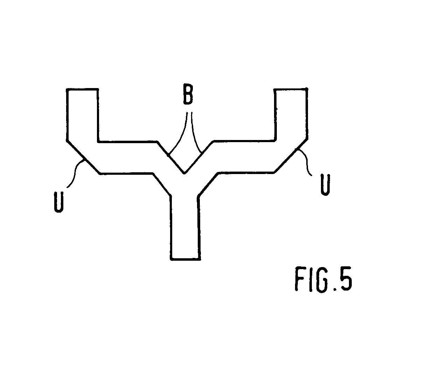

Fig. 4 gibt das Ergebnis einer derartigen Laseransteuerung wieder. Hier sind Wellenlängen möglicher Fabry-Perot-Moden in Abhängigkeit des Verhältnisses I3/I4 der nicht gemeinsame Segmente zweier Resonatoren durchsetzenden Ströme für verschiedene Werte des Gesamtstromes Σ I1 - I4 wiedergegeben.

Jeweils ein zusammenhängender Kurvenzug (z.B. Kurventeilstück PQ oder RS) bildet einen allein mit Hilfe des Verhältnisses der Ströme nicht gemeinsamer Segmente zweier Resonatoren einstellbaren Durchstimmbereich. Bei gleichbleibendem Gesamtstrom springt an den Enden eines solchen Kurventeilstücks (z.B. PQ) die Wellenlänge der selektierten Fabry-Perot-Mode auf einen um den Abstand zweier Mach-Zehnder-Verlustminima voneinander versetzen Wert (z.B. vom Punkt Q zum Punkt Q'). Wird jedoch zuvor durch Änderung des Gesamtstromes auf einen anderen Gesamtstrombereich (hier I1 = 25 mA) umgeschaltet, so erfolgt ein Übergang auf ein fast nahtlos ansetzendes Kurventeilstück RS. Der Durchstimmbereich wird dadurch um die Breite dieses Kurvenstückes erweitert. Durch weiteres Umschalten des Gesamtstromes (hier auf 40 mA bzw. 60 mA) können weitere Kurventeilstücke nahtlos angefügt werden, so daß als Gesamtdurchstimmbereich die in der Fig. mit K bezeichnete Kurve resultiert. Die einzelnen Kurvenstücke der Kurve K stellen also bei unveränderter geometrischer Gestaltung der Lasersegmente definierte Wellenlängenbereiche dar, zwischen denen durch Auswahl zugehöriger diskreter Gesamtstromwerte umgeschaltet werden kann.

Prinzipiell läßt sich durch Ändern eines Stromes durch ein nur einem Resonator angehörendes Segment sowohl das Stromverhältnis als auch der Gesamtstrom gleichzeitig ändern. Es dürfte jedoch nur in seltenen Fällen gelingen, diese Änderungen so aufeinander abzustimmen, daß gewünschte Moden im Bereich eines angrenzenden Kurvenstückes anschwingen.

Problemlos aufeinander abstimmen lassen sich die Änderungen von Stromverhältnis und Gesamtstrom jedoch durch Ansteuerung zweier Segmente, von denen eines nur den Gesamtstrom beeinflußt.

Eine besonders empfindliche Selektion einzelner Fabry-Perot-Moden mit außerordentlich guter Seitenmoden-Unterdrückung wird erreicht, wenn der Abstand der Mach-Zehnder-Verlustminima nur geringfügig unterschiedlich zum Abstand der Fabry-Perot-Moden voneinander eingestellt wird. Es können dann durch geringfügige Änderung des Abstandes der Mach-Zehnder-Verlustminima voneinander, verschiedene Fabry-Perot-Moden mit den Mach-Zehnder-Verlustkurven in Koinzidenz gebracht werden. Diese mit Mach-Zehnder-Verlustminima zusammenfallenden Fabry-Perot-Moden liegen weiter voneinander entfernt als unmittelbar benachbarte Fabry-Perot-Moden und sind infolgedessen leicht durch Verschieben der Verlustkurve des Lasermaterials durch Ändern des Laser-Gesamtstromes selektierbar.

In Fig. 5 ist ein zentrales Segment wiedergegeben, bei dem die Strahlteilung durch ein Biprisma B erfolgt und bei dem durch Verwendung von Strahlablenkspiegeln U gekrümmte Segmentteile vermieden sind.

### Beschreibung für folgende Vertragsstaaten : NL, SE

Die Erfindung betrifft einen interferometrischen Halbleiterlaser nach dem Oberbegriff des Patentanspruchs 1.

Ein solcher Laser ist z.B. aus einem Aufsatz von M. Schilling et al mit dem Titel: "Integrated Interferometric Injection Laser: Novel Fast and Broad-Band Tunable Monolithic Light Source" in IEEE Journal of Quantum Electronics, Vol. 27, No. 6, June 1991, pp 1616 - 1622 bekannt. Er wird wegen seiner in der einfachsten Ausführung typischen, einem Y ähnlichen Form, auch Y-Laser, genauer YCC-I³-Laser genannt.

Ein solcher Laser weist zwei miteinander gekoppelte Resonatorstrecken auf, welche sich, ausgehend von der Endfläche der Wurzel des Y bis zu den Spiegel-Endflächen der beiden Arme des Y erstrecken. In beiden Resonatoren können sich Fabry-Perot-Moden ausbilden, die, da die Wellenlänge im Vergleich zur Resonatorlänge meist klein ist, sehr dicht liegen. Welche Moden anschwingen, hängt zum einen von den Gewinnkurven des Lasermaterials der aktiven Segmente ab, zum anderen von dem den aktiven Segmenten der Resonatoren zugeführten Strom, der über eine Änderung des Brechungsindex in den strombeeinflußten Segmenten eine Verschiebung der Wellenlängen der Fabry-Perot-Moden in den Resonatoren bewirkt. Hierbei wird durch eine Stromänderung in einem gemeinsamen aktiven Segment eine Verschiebung in allen dieses Segment enthaltenden Resonatoren, durch eine Stromänderung in einem nur einem Resonator angehörenden aktiven Segment eine Verschiebung der Wellenlängen der Fabry-Perot-Moden dieses Resonators gegenüber den Wellenlängen der Fabry-Perot-Moden der anderen Resonatoren bewirkt.

Eine Selektion einer einzelnen Fabry-Perot-Mode vorgegebener Wellenlänge bei ausreichender Seitenmoden-Unterdrückung ist deshalb schwierig, weil einerseits, bei Verwendung der flach ausgebildeten Gewinnkurve des Lasermaterials zur Modenselektion, der Gewinnvorsprung einer Fabry-Perot-Mode gegenüber den dicht benachbarten Seitenmoden klein ist und die Auswahl einer Mode gegenüber ihren Nachbarmoden deshalb die exakte Überlagerung der Gewinnkurvenmaxima aller aktiven Segmente erfordert, und weil andererseits, bei Ausnutzung der oben beschriebenen Verschiebung der Fabry-Perot-Modenkämme zweier miteinander gekoppelter Resonatoren (sogenannte Supermoden-Selektion) kleinste Stromänderungen große Wellenlängensprünge verursachen können, was das System schwer beherrschbar macht. Ein Durchstimmen eines in dem o.g. Aufsatz beschriebenen Lasers ist deshalb in der Regel nicht nach einem einfachen Schema möglich, sondern erfordert für jede Wellenlänge sehr exakte, unterschiedliche Einstellungen der verschiedenen Ströme in den aktiven Segmenten. Diese Stromeinstellungen müssen durch Versuche ermittelt und abgespeichert werden.

Der Erfindung liegt die Aufgabe zugrunde, einen Halbleiterlaser der eingangs beschriebenen Art anzugeben, der hinsichtlich einer kontrollierbaren Wellenlängeneinstellung, hinsichtlich der Zahl der zum Durchstimmen zu verändernden Ströme und hinsichtlich der beim Verändern dieser Ströme geforderten Toleranzen verbessert ist.

Diese Aufgabe wird durch die im Patentanspruch 1 angegebenen Merkmale gelöst.

Durch die stark unterschiedlich ausgelegten optischen Längen zweier miteinander gekoppelter Resonatoren entsteht innerhalb des Halbleiterlasers ein interferometrisches System, das die Eigenschaften eines Mach-Zehnder-Filters besitzt, wie es z.B. zur Untersuchung der Linienbreite und des Rauschens bei Multimode-Lasern bekannt ist.

Das Mach-Zehnder-Filter moduliert hier die flache Gewinnkurve des Lasermaterials in der Art, daß stärker gekrümmte Bereiche entstehen, innerhalb derer benachbarte Fabry-Perot-Moden größere Gewinnunterschiede aufweisen und damit leichter einzeln selektiert werden können. Die Lage der durch die Mach-Zehnder-Filterwirkung erzeugten Gewinn-Maxima auf der Wellenlängen-Achse ist dabei wesentlich genauer und einfacher einzustellen als die des Maximums mehrerer überlagerter Gewinnkurven der einzelnen Segmente.

Durch die Verwendung der Mach-Zehnder-Gewinnmaxima als zusätzliches Selektionsmittel wird es möglich, Halbleiterlaser für ganz bestimmte Anwendungen herzustellen und anwendungsbezogen einzustellen.

So läßt sich durch eine entsprechende Wahl der Differenz der optischen Weglängen zweier Resonatoren der Wellenlängenabstand zwischen benachbarten Mach-Zehnder-Gewinnmaxima und damit auch deren Krümmung bereits bei der Laserherstellung voreinstellen.

Eine genaue Endeinstellung kann durch Variation der Ströme der gemeinsamen oder der unterschiedlichen Resonatoren angehörigen Segmente vorgenommen werden.

Ausgestaltungen des Halbleiterlasers nach der Erfindung sind in den Unteransprüchen 2 bis 9 angegeben. So sieht Anspruch 2 unterschiedliche geometrische Längen der nicht gemeinsamen Segmente zweier Resonatorstrecken zur Herstellung einer Differenz der optischen Weglängen vor, während die in Anspruch 3 beschriebene Ausgestaltung dies durch die Verwendung von Materialien mit unterschiedlichen optischen Eigenschaften in den nicht gemeinsamen Segmenten erreicht.

Anspruch 4 betrifft die Anordnung des gesamten Lasers auf einem einzigen monolithischen Substrat. Hierbei können, wie z.B. in Anspruch 5, vorteilhaft verschiedene Formen der Segmentanordnung realisiert sein, wobei auch einzelne Segmente, z.B. das zentrale Segment (2), gemäß Anspruch 6, aktive und passive Teile aufweisen können.

Eine in Anspruch 7 wiedergegebene Weiterbildung der Erfindung sieht als zentrales Segment eine diskret aufgebaute Strahlteiler-Linsen-Optik, eine in Anspruch 8 beschriebene Ausgestaltung eine Lichtleitfaser-Koppelanordnung vor. Damit können die miteinander gekoppelten aktiven Segmente auf verschiedenen, ggf. unterschiedlichen Substraten unabhängig voneinander hergestellt werden.

Die Ansprüche 9 bis 13 betreffen verschiedene mögliche Betriebsweisen des erfindungsgemäßen Halbleiterlasers.

Gemäß Patentanspruch 9 wird hierbei das Verhältnis der Ströme in zwei unterschiedlichen Resonatoren angehörenden Segmenten variiert. Damit kann die Lage eines durch Interferenz des in zwei Resonatoren mit unterschiedlichen optischen Weglängen entstehenden Lichtes erzeugten Mach-Zehnder-Gewinnmaximums - das dem Minimum einer Mach-Zehnder-Verlustkurve entspricht - auf der Wellenlängenachse eingestellt und auf diese Weise eine einzelne Fabry-Perot-Mode aus einer Reihe einander benachbarter Fabry-Perot-Moden zum Anschwingen gebracht werden.

Patentanspruch 10 betrifft eine besonders einfache und effiziente Art der Ansteuerung des Lasers. Indem der Gesamtstrom des Lasers konstant gehalten wird verändern sich die Lage des Gewinnmaximums des Lasermaterials und die Wellenlängen möglicher Fabry-Perot-Moden nicht wesentlich und das absolute Mach-Zehnder-Gewinnmaximum kann zur Selektion einzelner Fabry-Perot-Moden über den Fabry-Perot-Modenkamm hinweggeschoben werden. Das Stromverhältnis kann z.B. mittels eines Potentiometers eingestellt werden, dessen Endanschlüsse mit den Lasersegmenten und dessen Abgriff mit einer Konstantstromquelle verbunden sind.

Eine in Patentanspruch 11 beschriebene Betriebsweise ermöglicht das Schieben der Lasermaterial-Gewinnkurve über die Wellenlängenachse und damit, über die Anwahl unterschiedlicher Mach-Zehnder-Gewinnmaxima, die Auswahl bestimmter Wellenlängenbereiche. Es kann so, gemäß Patentanspruch 12, am Ende eines zunächst angewählten Wellenlängenbereichs auf einen Nachbar-Wellenlängenbereich umgeschaltet und damit der Durchstimmbereich des Lasers erheblich erweitert werden. Die Ansteuerung des Lasers bleibt dabei einfach. In gleicher Weise können, unter Konstanthaltung des Verhältnisses der in unterschiedlichen Resonatoren angehörenden Segmenten fließenden Ströme, vorgegebene, in Zentren verschiedener Mach-Zehnder-Gewinnmaxima liegende Fabry-Perot-Moden mit großer Strom-Toleranz, nur durch Variation des über ein oder mehrere gemeinsame Segmente fließenden Gesamtstromes angewählt werden. Ein auf diese Weise betriebener Laser nach der Erfindung eignet sich insbesondere zur optischen Kanalumschaltung in nachrichtentechnischen Anwendungen.

Mit einer Ausgestaltung nach Anspruch 13 kann eine Selektion einzelner Fabry-Perot-Moden mit besonders guter Seitenmoden-Unterdrückung ausgeführt werden.

Anhand mehrerer Figuren sollen nun ein Beispiel zum Stand der Technik und Ausführungsbeispiele des Halbleiterlasers nach der Erfindung ausführlich beschrieben und die Arbeitsweise des Halbleiterlasers erklärt werden.
- Fig. 1: zeigt einen sogenannten Y-Laser nach dem Stand der Technik,
- Fig. 2: zeigt die Anordnung der Segmente bei einem Y-Laser nach der Erfindung,
- Fig. 3: zeigt eine Folge von Mach-Zehnder-Verlustkurven bei unterschiedlich langen, verschiedenen Resonatorstrecken zugeordneten Segmenten,
- Fig. 4: zeigt Durchstimmbereiche des Halbleiterlasers nach der Erfindung,
- Fig. 5: zeigt ein unter Verwendung eines Biprismas und Strahablenkspiegeln aufgebautes zentrales Segment.

Fig. 1 zeigt einen monolithisch aufgebauten Y-Laser nach dem Stand der Technik. Der vertikale Schichtenaufbau dieses Lasers ist entlang der gesamten Y-förmigen Struktur der Laser-Kavität gleich und kann z.B. dem im eingangs genannten Aufsatz, in Fig. 1 und der zugehörigen Beschreibung beschiebenen Aufbau entsprechen. Eine laseraktive Schicht 6 erstreckt sich ohne Unterbrechung entlang der gesamten Y-förmigen, an ihrer Oberfläche durch eine Metallschicht abgedeckten Strucktur. Diese Metallschicht ist an bestimmten Stellen 5 elektrisch aufgetrennt. Die voneinander getrennten Teile der Metallschicht bestimmen die Längen von insgesamt 4 einzeln ansteuerbaren Lasersegmenten 1 bis 4. In dem dargestellten Y-Laser können sich im wesentlichen zwei Resonatoren ausbilden, die jeweils von der reflektierenden Endfläche an der Wurzel der Y-förmigen Struktur zu der ebenfalls reflektierenden Endfläche eines der Arme reichen. In geringerem Maße kann sich auch in einem sich von der Wurzel zur Verzweigung erstreckenden Teilstück der Y-Struktur eine sogenannte Zwickel-Mode ausbilden. Als gemeinsame Segmente beider Resonatorstrecken sind somit das Wurzelsegment 1 und das den Strahlteiler enthaltende Segment 2 anzusehen. Die verbleibenden Segmente 3 und 4 beeinflussen jeweils einen der Resonatoren. Die Stromzuführung zu den Segmenten erfolgt über in der Fig. nicht dargestellte, direkte Kontaktierung der Metallschicht.

Fig. 2 zeigt schematisch die Anordnung der Segmente bei einem Halbleiterlaser nach der Erfindung. Hier ist das Segment 3 wesentlich kürzer als das Segment 4 ausgeführt. Dies führt zu stark unterschiedlichen Längen der miteinander gekoppelten Resonatoren. Der dargestellte Laser verhält sich deshalb wie ein Mach-Zehnder-Filter und moduliert die flache Gewinnkurve des Lasermaterials mit einer Folge wesentlich schärfer als diese gekrümmter Mach-Zehnder-Gewinnkurven.

Fig. 3 zeigt den genannten Gewinnkurven entsprechende Verlustkurven V eines unterschiedliche Resonatoren aufweisenden Halbleiterlasers. Es ist hier der Verlust über der Wellenlänge für einen vorgegebenen festen Längenunterschied der Resonatoren aufgetragen. Bei Erhöhung der Segmentströme über einen für den Laserbetrieb notwendigen Mindestwert hinaus werden solche Fabry-Perot-Moden anschwingen, deren Wellenlängen an Stellen liegen, an denen die Verluste am niedrigsten (der Gewinn am höchsten) sind. Nachdem die Mach-Zehnder-Verlustkurven im Bereich ihrer Minima wesentlich stärker gekrümmt sind als ihre Einhüllende H, die Verlustkurve des Lasermaterials, ist hier eine wesentlich höhere Selektivität bei der Auswahl einzelner Fabry-Perot-Moden gegeben und eine viel bessere Seitenmodenunterdrückung möglich als dies die flache Verlustkurve des Lasermaterials zulassen würde.

Zur Auswahl einer Fabry-Perot-Mode wird z.B. das Verhältnis der Ströme in den beiden nicht gemeinsamen Segmenten der beiden interferierenden Resonatorstrecken variiert. Um eine Verschiebung der Verlustkurve des Lasermaterials, der Einhüllenden der Mach-Zehnder-Verlustkurven zu vermeiden, wird dabei der Gesamtstrom konstant gehalten. Damit verschieben sich die Minima der Mach-Zehnder-Verlustkurven V in ihrer Wellenlänge entlang der Einhüllenden H und es schwingt jeweils die Fabry-Perot-Mode an, die im Bereich des tiefsten Minimums aller Mach-Zehnder-Verlustkurven liegt. Wegen der zu beiden Seiten ihrer Minima steil ansteigenden Werte der Mach-Zehnder-Verlustkurven können nah benachbarte Fabry-Perot-Moden nicht gleichzeitig anschwingen. Eine Fabry-Perot-Mode im Bereich der nächsten Mach-Zehnder-Verlustkurve schwingt erst an, wenn die zuvor zur Modenauswahl benutzte Verlustkurve V so weit entlang der Hüllkurve H zu höheren Verlustwerten hin verschoben wurde, daß das Minimum der nächsten Mach-Zehnder-Verlustkurve tiefer zu liegen kommt als das der zuvor benutzten Verlustkurve und deshalb einen geringeren Verlust aufweist. Es springt dann eine Fabry-Perot-Mode mit stark unterschiedlicher Wellenlänge im Bereich dieser nächsten Mach-Zehnder-Verlustkurve an. Immerhin läßt sich aber allein durch Ändern des Verhältnisses der in verschiedenen Resonatoren angehörenden Segmenten fließenden Ströme die Anwahl einzelner benachbarter Fabry-Perot-Moden bei guter Seitenmoden-Unterdrückung in einem Wellenlängenbereich, der dem Abstand zweier Mach-Zehnder-Verlustminima voneinander entspricht, vornehmen.

Da der Abstand der Mach-Zehnder-Verlustminima durch die Differenz der Resonatorlängen bestimmt ist und damit nahezu frei gewählt werden kann, kann der Durchstimmbereich enger oder breiter gewählt und so an die gewünschten Arbeitsbedingungen angepaßt werden. Wie breit der Durchstimmbereich eingestellt werden kann, hängt vom Abstand der Fabry-Perot-Moden und von der geforderten wirksamen Seitenmoden-Unterdrückung ab, welche bei ausschließlicher Variation des o.g. Stromverhältnisses bei Konstanthaltung des Gesamtstromes mit zunehmender Breite des Durchstimmbereiches schlechter wird.

Es gibt jedoch eine Möglichkeit, eine Verbreiterung des Durchstimmbereiches zu erreichen, ohne eine Verschlechterung der Seitenmoden-Unterdrückung in Kauf zu nehmen. Dies wird durch eine Änderung des Gesamtstromes aller Laser-Segmente unter Beibehaltung des eingestellten o.g. Stromverhältnisses erreicht. Eine Gesamtstromänderung, die am einfachsten durch eine Stromänderung in einem beiden Resonatoren gemeinsam angehörenden Lasersegment erreicht wird, verschiebt die Verlustkurve des Lasermaterials, also die Hüllkurve H der Mach-Zehnder-Verlustkurven in ihrer Wellenlänge. Wird nun die Hüllkurve durch Änderung des Gesamtstromes mit der zur Modenauswahl benutzten, durch Änderung des o.g. Stromverhältnisses verschobenen Mach-Zehnder-Verlustkurve mitverschoben, so läßt sich der Durchstimmbereich bei unverändert guter Seitenmoden-Unterdrückung wesentlich verbreitern.

Fig. 4 gibt das Ergebnis einer derartigen Laseransteuerung wieder. Hier sind Wellenlängen möglicher Fabry-Perot-Moden in Abhängigkeit des Verhältnisses I3/I4 der nicht gemeinsame Segmente zweier Resonatoren durchsetzenden Ströme für verschiedene Werte des Gesamtstromes Σ I1 - I4 wiedergegeben.

Jeweils ein zusammenhängender Kurvenzug (z.B. Kurventeilstück PQ oder RS) bildet einen allein mit Hilfe des Verhältnisses der Ströme nicht gemeinsamer Segmente zweier Resonatoren einstellbaren Durchstimmbereich. Bei gleichbleibendem Gesamtstrom springt an den Enden eines solchen Kurventeilstücks (z.B. PQ) die Wellenlänge der selektierten Fabry-Perot-Mode auf einen um den Abstand zweier Mach-Zehnder-Verlustminima voneinander versetzen Wert (z.B. vom Punkt Q zum Punkt Q'). Wird jedoch zuvor durch Änderung des Gesamtstromes auf einen anderen Gesamtstrombereich (hier I1 = 25 mA) umgeschaltet, so erfolgt ein Übergang auf ein fast nahtlos ansetzendes Kurventeilstück RS. Der Durchstimmbereich wird dadurch um die Breite dieses Kurvenstückes erweitert. Durch weiteres Umschalten des Gesamtstromes (hier auf 40 mA bzw. 60 mA) können weitere Kurventeilstücke nahtlos angefügt werden, so daß als Gesamtdurchstimmbereich die in der Fig. mit K bezeichnete Kurve resultiert. Die einzelnen Kurvenstücke der Kurve K stellen also bei unveränderter geometrischer Gestaltung der Lasersegmente definierte Wellenlängenbereiche dar, zwischen denen durch Auswahl zugehöriger diskreter Gesamtstromwerte umgeschaltet werden kann.

Prinzipiell läßt sich durch Ändern eines Stromes durch ein nur einem Resonator angehörendes Segment sowohl das Stromverhältnis als auch der Gesamtstrom gleichzeitig ändern. Es dürfte jedoch nur in seltenen Fällen gelingen, diese Änderungen so aufeinander abzustimmen, daß gewünschte Moden im Bereich eines angrenzenden Kurvenstückes anschwingen.

Problemlos aufeinander abstimmen lassen sich die Änderungen von Stromverhältnis und Gesamtstrom jedoch durch Ansteuerung zweier Segmente, von denen eines nur den Gesamtstrom beeinflußt.

Eine besonders empfindliche Selektion einzelner Fabry-Perot-Moden mit außerordentlich guter Seitenmoden-Unterdrückung wird erreicht, wenn der Abstand der Mach-Zehnder-Verlustminima nur geringfügig unterschiedlich zum Abstand der Fabry-Perot-Moden voneinander eingestellt wird. Es können dann durch geringfügige Änderung des Abstandes der Mach-Zehnder-Verlustminima voneinander, verschiedene Fabry-Perot-Moden mit den Mach-Zehnder-Verlustkurven in Koinzidenz gebracht werden. Diese mit Mach-Zehnder-Verlustminima zusammenfallenden Fabry-Perot-Moden liegen weiter voneinander entfernt als unmittelbar benachbarte Fabry-Perot-Moden und sind infolgedessen leicht durch Verschieben der Verlustkurve des Lasermaterials durch Ändern des Laser-Gesamtstromes selektierbar.

In Fig. 5 ist ein zentrales Segment wiedergegeben, bei dem die Strahlteilung durch ein Biprisma B erfolgt und bei dem durch Verwendung von Strahlablenkspiegeln U gekrümmte Segmentteile vermieden sind.

## Patentansprüche (Patentansprüche für folgende(n) Vertragsstaat(en): DE, GB, FR)

1. Verfahren zum Betrieb eines interferometrischen Halbleiterlasers, der eine Kavität in Gestalt eines Y mit mindestens drei einzeln ansteuerbaren, über ein als Strahlteiler wirkendes aktives oder passives zentrales Segment (2) miteinander gekoppelten aktiven Segmenten besitzt, wobei die Anordnung der Segmente derart vorgenommen ist, daß zwei Resonatorstrecken gebildet werden, welche mindestens ein gemeinsames aktives Segment enthalten und von denen mindestens eine ein aktives Segment enthält, das der anderen Resonatorstrecke nicht angehört, und sich die optische Wegstrecke der einen Resonatorstrecke bei fehlender oder gleicher Ansteuerung der aktiven Segmente von der optischen Weglänge der anderen Resonatorstrecke unterscheidet,
**dadurch gekennzeichnet,** daß über mindestens zwei Segmente (3, 4) des Halbleiterlasers, von denen mindestens eines einer Resonatorstrecke ausschließlich angehört, ein Stromfluß erzeugt wird, und daß das Verhältnis (I3/I4) der beiden Stromflüsse zueinander zur Einstellung einer gewünschten Lage des absoluten Minimums einer durch die unterschiedlichen optischen Weglängen der durch die Stromflüsse beeinflußten Resonatorstrecken bedingte Mach-Zehnder-Verlustkurve (V) auf der Wellenlängenachse variiert wird.

2. Verfahren nach Anspruch 1, dadurch gekennzeichnet, daß das Verhältnis der Stromflüsse unter Konstanthaltung des Gesamtstromes variiert wird.

3. Verfahren nach Anspruch 1 oder 2, dadurch gekennzeichnet, daß zusätzlich ein Stromfluß über mindestens ein beiden Resonatorstrecken gemeinsam angehörendes Segment (1) erzeugt wird.

4. Verfahren nach Anspruch 3, dadurch gekennzeichnet, daß der Strom über das beiden Resonatorstrecken gemeinsam angehörende Segment (1) zur Umschaltung zwischen Wellenlängenbereichen oder zwischen in diesen Wellenlängenbereichen liegenden, vorausgewählten Wellenlängen stufenweise verändert wird.

5. Verfahren nach Anspruch 1 bis 4, dadurch gekennzeichnet, daß die Resonatorlängen vorab so eingestellt werden, daß der Abstand der Minima der Mach-Zehnder-Verlustkurven voneinander in derselben Größenordnung liegt wie der Abstand der Fabry-Perot-Moden voneinander, und daß die Auswahl einer gewünschten Fabry-Perot-Mode durch Herbeiführen einer Koinzidenz zwischen dem Minimum einer Mach-Zehnder-Verlustkurve und dem Minimum der Verlustkurve des die aktiven Segmente bildenden lichtdurchlässigen Materials bei der Wellenlänge der gewünschten Fabry-Perot-Mode durch Variation des Verhältnisses der Stromflüsse über interferierenden Resonatoren angehörende aktive Segmente und/oder durch Variation des Laser-Gesamtstromes erfolgt.

## Patentansprüche (Patentansprüche für folgende(n) Vertragsstaat(en): NL, SE)

1. Interferometrischer Halbleiterlaser mit einer Kavität in Gestalt eines Y, mit mindestens drei einzeln ansteuerbaren aktiven Segmenten (1, ... , 4), welche über ein als Strahlteiler wirkendes, aktives oder passives zentrales Segment (2) miteinander gekoppelt sind, wobei die Anordnung der Segmente derart vorgenommen ist, daß zwei Resonatorstrecken gebildet werden, welche mindestens ein gemeinsames aktives Segment enthalten und von denen mindestens eine ein aktives Segment enthält, das der anderen Resonatorstrecke nicht angehört,
**dadurch gekennzeichnet**, daß sich die optische Weglänge der einen Resonatorstrecke bei fehlender oder gleicher Ansteuerung der aktiven Segmente von der optischen Weglänge der anderen Resonatorstrecke unterscheidet, derart, daß durch unterschiedlichen optischen Weglängen der Resonatorstrecken die durch eine Mach-Zehnder-Filterwirkung entstandenen Gewinn-Maxima auf der Wellenlängenachse festgelegt werden.

2. Interferometrischer Halbleiterlaser nach Anspruch 1, dadurch gekennzeichnet, daß die unterschiedlichen optischen Weglängen der Resonatorstrecken durch unterschiedliche geometrische Längen der Resonatorstrecken bedingt sind.

3. Interferometrischer Halbleiterlaser nach Anspruch 1, dadurch gekennzeichnet, daß die unterschiedlichen optischen Weglängen der Resonatorstrecken durch Einsatz von Werkstoffen mit unterschiedlichen optischen Eigenschaften zum Aufbau der in den Resonatorstrecken enthaltenen, nicht gemeinsamen oder diese unterschiedlich beinflussenden aktiven Segmente hergestellt sind.

4. Interferometrischer Halbleiterlaser nach Anspruch 1 , dadurch gekennzeichnet, daß das zentrale Segment zusammen mit den mit ihm gekoppelten aktiven Segmenten auf einem einzigen monolithischen Substrat hergestellt ist.

5. Interferometrischer Halbleiterlaser nach Anspruch 4, dadurch gekennzeichnet, daß das zentrale Segment (2) einen Strahlteiler und einen linearen Segmentteil aufweist.

6. Interferometrischer Halbleiterlaser nach einem der Ansprüche 4 oder 5, dadurch gekennzeichnet, daß das zentrale Segment laseraktive Teile und passive Teile aufweist.

7. Interferometrischer Halbleiterlaser nach Anspruch 1 , dadurch gekennzeichnet, daß das zentrale Segment von einer diskret aufgebauten Strahlteiler-Linsen-Optik gebildet wird.

8. Interferometrischer Halbleiter laser nach einem der Ansprüche 1 bis 3, dadurch gekennzeichnet, daß als zentrales Segment eine passive Lichtleifaseranordnung dient.

9. Verfahren zum Betrieb eines Halbleiterlasers nach einem der Patentansprüche 1 bis 8,
**dadurch gekennzeichnet,** daß über mindestens zwei Segmente (3, 4) des Lasers, von denen eines mindestens einer Resonatorstrecke ausschließlich angehört, ein Stromfluß erzeugt wird, und daß das Verhältnis (I3/I4) der beiden Stromflüsse zueinander zur Einstellung einer gewünschten Lage des absoluten Minimums einer durch die unterschiedlichen optischen Weglängen der durch die Stromflüsse beeinflußten Resonatorstrecken bedingten Mach-Zehnder-Verlustkurven (V) auf der Wellenlängenachse variiert wird.

10. Verfahren nach Anspruch 9 dadurch gekennzeichnet, daß das Verhältnis der Stromflüsse unter Konstanthaltung des Gesamtstromes variiert wird.

11. Verfahren nach Anspruch 9 oder 10, dadurch gekennzeichnet, daß zusätzlich ein Stromfluß über mindestens ein beiden Resonatorstrecken gemeinsam angehörendes Segment (1) erzeugt wird.

12. Verfahren nach Anspruch 11 dadurch gekennzeichnet, daß der Strom über das beiden Resonatorstrecken gemeinsam angehörende Segment (1) zur Umschaltung zwischen Wellenlängenbereichen oder zwischen in diesen Wellenlängenbereichen liegenden, vorausgewählten Wellenlängen stufenweise verändert wird.

13. Verfahren nach Anspruch 9 bis 12, dadurch gekennzeichnet, daß die Resonatorlängen vorab so eingestellt werden, daß der Abstand der Minima der Mach-Zehnder-Verlustkurven voneinander in derselben Größenordnung liegt wie der Abstand der Fabry-Perot-Moden voneinander, und daß die Auswahl einer gewünschten Fabry-Perot-Mode durch Herbeiführen einer Koinzidenz zwischen dem Minimum einer Mach-Zehnder-Verlustkurve und dem Minimum der Verlustkurve des die aktiven Segmente bildenden lichtdurchlässigen Materials bei der Wellenlänge der gewünschten Fabry-Perot-Mode durch Variation des Verhältnisses der Stromflüsse über interferierenden Resonatoren angehörende aktive Segmente und/oder durch Variation des Laser-Gesamtstromes erfolgt.

## Claims (Claims for the following Contracting State(s): DE, GB, FR)

1. Process for operating an interferometric semiconductor laser, which has a Y-shaped cavity, having at least three individual, triggerable, active segments coupled together via an active or passive central segment (2) acting as a beam splitter, the segments being arranged so that two resonator paths are produced which include at least one common active segment and at least one of which said resonator paths contains an active segment not belonging to the other resonator path, and which distinguishes the optical path length of the one resonator path in the event of no drive or identical drive for the active segments, from the optical path length of the other resonator path, **characterised in that** a current flow is produced via at least two segments (3, 4) of the semiconductor laser, at least one of which belongs exclusively to one resonator path, and that the ratio (I3/I4) between the two current flows is varied to adjust a desired position of the absolute minimum of a Mach-Zehnder loss curve (V) on the wavelength axis due to the different optical path lengths of the resonator paths influenced by the current flows.

2. Process according to Claim 1, **characterised in that** the ratio of the current flows is varied while maintaining the total current constant.

3. Process according to Claim 1 or 2, **characterised in that** additionally, a current flow is produced via at least one segment (1) that is common to both resonator paths.

4. Process according to Claim 3, **characterized in that** the current is varied step-by-step via the segment (1) that is common to both resonator paths, in order to switch between wavelength ranges or between preselected wavelengths lying within these wavelength ranges.

5. Process according to Claim 1 to 4, **characterised in that** the resonator lengths are set in advance so that the distance between the minima of the Mach-Zehnder loss curves is of the same order of magnitude as the distance between the Fabry-Perot modes, and that a desired Fabry-Perot mode is selected by causing a coincidence between the minimum of a Mach-Zehnder loss curve and the minimum of the loss curve of the light-transmitting material forming the active segments at the wavelength of the desired Fabry-Perot mode, by varying the ratio of the current flows via active segments belonging to interfering resonators and/or by varying the total laser current.

## Claims (Claims for the following Contracting State(s): NL, SE)

1. An interferometric semiconductor laser having a Y-shaped cavity, and with at least three individual, triggerable, active segments (1, ... , 4), which are coupled together via an active or passive central segment (2) acting as a beam splitter, the segments being arranged so that two resonator paths are produced which include at least one common active segment and at least one of which said resonator paths contains an active segment not belonging to the other resonator path, **characterised in that** in the event of no drive or equal drive for the active segments, the optical path length of the one resonator path is distinguished from the optical path length of the other resonator path so that, due to the different optical path lengths of the resonator paths, the gain maxima due to a Mach-Zehnder filter effect are determined on the path length axis.

2. Interferometric semiconductor laser according to Claim 1, **characterised in that** the different optical path lengths of the resonator paths are determined by different geometrical lengths of the resonator paths.

3. Interferometric semiconductor laser according to Claim 1, **characterised in that** the different optical path lengths of the resonator paths are produced by using materials having different optical characteristics for the construction of the active segments contained in the resonator paths, said active elements not influencing these resonator paths jointly or differently.

4. Interferometric semiconductor laser according to Claim 1, **characterised in that** the central element, together with the active segments coupled to it, is manufactured on a single monolithic substrate.

5. Interferometric semiconductor laser according to Claim 4, **characterised in that** the central segment (2) has a beam splitter and a linear segment part.

6. Interferometric semiconductor laser according to one of the Claims 4 or 5, **characterised in that** the central segment has laser-active parts and passive parts.

7. Interferometric semiconductor laser according to Claim 1, **characterised in that** the central segment is constructed from a discrete beam splitter/lens optical system.

8. Interferometric semiconductor laser according to one of the Claims 1 to 3, **characterised in that** a passive optical fibre arrangement is used as the central element.

9. Process for operating a semiconductor laser according to one of the Claims 1 to 8, **characterised in that** a current flow is produced via at least two segments (3, 4) of the laser, at least one of which belongs exclusively to one resonator path, and that the ratio (I3/I4) between the two current flows is varied to adjust a desired position of the absolute minimum of a Mach-Zehnder loss curve (V) on the wavelength axis due to the different optical path lengths of the resonator paths influenced by the current flows.

10. Process according to Claim 9, **characterised in that** the ratio of the current flows is varied while maintaining the total current constant.

11. Process according to Claim 9 or 10, **characterised in that** additionally, a current flow is produced via at least one segment (1) that is common to both resonator paths.

12. Process according to claim 11, **characterized in that** the current is varied step-by-step via the segment (1) that is common to both resonator paths, in order to switch between wavelength ranges or between preselected wavelengths lying within these wavelength ranges.

13. Process according to Claim 9 to 12, **characterised in that** the resonator lengths are set in advance so that the distance between the minima of the Mach-Zehnder loss curves is of the same order of magnitude as the distance between the Fabry-Perot modes, and that a desired Fabry-Perot mode is selected by causing a coincidence between the minimum of a Mach-Zehnder loss curve and the minimum of the loss curve of the light-transmitting material forming the active segments at the wavelength of the desired Fabry-Perot mode, by varying the ratio of the current flows via active segments belonging to interfering resonators and/or by varying the total laser current.

## Revendications (Revendications pour l'(les) Etat(s) contractant(s) suivant(s): DE, GB, FR)

1. Procédé pour l'exploitation d'un laser interférométrique à semi-conducteur comportant une cavité en forme de Y avec au moins trois segments actifs actionnables couplés les uns aux autres par l'intermédiaire d'un segment central actif ou passif (2) jouant le rôle de séparateur de faisceau, l'agencement des segments étant tel que deux voies de résonateurs comprenant au moins un segment actif commun se forment, dont au moins l'une comporte un segment actif n'appartenant pas à l'autre voie de résonateur, et la distance optique d'une voie de résonateur diffère, pour une commande non existante ou égale des segments actifs, de la distance optique de l'autre voie de résonateur, caractérisé par le fait qu'un courant est créé et traverse deux segments (3, 4) au moins du laser à semi-conducteur, l'un au moins appartenant exclusivement à une voie de résonateur, et que le rapport (I3/I4) des intensités des deux courants est modifié afin d'ajuster sur l'axe des longueurs d'ondes une position souhaitée du minimum absolu d'une courbe de pertes Mach-Zehnder (V) conditionnée par les différentes longueurs de voies optiques des résonateurs traversés par les courants.

2. Procédé conformément à la spécification 1, caractérisé par le fait qu'on varie le rapport des courants tout en maintenant constante l'intensité du courant total.

3. Procédé conformément à la spécification 1 ou 2, caractérisé par le fait qu'un courant supplémentaire est créé sur au moins un segment (1) commun aux deux voies de résonateurs.

4. Procédé conformément à la spécification 3, caractérisé par le fait qu'on varie le courant traversant le segment (1) commun aux deux voies de résonateurs pour commuter progressivement entre des gammes de longueurs d'ondes ou entre des longueurs d'ondes auparavant sélectionnées de ces gammes de longueurs d'ondes.

5. Procédé conformément aux spécifications 1 à 4, caractérisé par le fait que les longueurs des résonateurs sont au préalable ajustées de telle sorte que l'écart entre les minimums des courbes de pertes Mach-Zehnder soit approximativement égal à l'écart entre les modes de Fabry et Pérot, et que la sélection du mode de Fabry et Pérot souhaité se fait en réalisant la coïncidence entre le minimum d'une courbe de pertes Mach-Zehnder et le minimum de la courbe de pertes du matériau transparent constituant les segments actifs, ceci à la longueur d'onde du mode de Fabry et Pérot souhaité, par variation du rapport des courants traversant les segments actifs de résonateurs interférents et/ou variation du courant total du laser.

## Revendications (Revendications pour l'(les) Etat(s) contractant(s) suivant(s): NL, SE)

1. Laser interférométrique à semi-conducteur comportant une cavité en forme de Y avec au moins trois segments actifs actionnables (1, ..., 4) couplés les uns aux autres par l'intermédiaire d'un segment central actif ou passif (2) jouant le rôle de séparateur de faisceau, l'agencement des segments étant tel que deux voies de résonateurs comprenant au moins un segment actif commun se forment, dont au moins l'une comporte un segment actif n'appartenant pas à l'autre voie de résonateur, caractérisé par le fait que la distance optique d'une voie de résonateur diffère, pour une commande non existante ou égale des segments actifs, de la distance optique de l'autre voie de résonateur, ceci de telle sorte que, étant donné les distances optiques différentes des voies de résonateurs, les maximums de gains créés sur l'axe des longueurs d'ondes sous l'effet du filtre de Mach-Zehnder sont fixés.

2. Laser interférométrique à semi-conducteur conformément à la spécification 1, caractérisé par le fait que les différentes longueurs de voies optiques des résonateurs sont conditionnées par des longueurs géométriques différentes des voies de résonateurs.

3. Laser interférométrique à semi-conducteur conformément à la spécification 1, caractérisé par le fait que les différentes longueurs de voies optiques des résonateurs résultent de l'utilisation d'éléments possédant des propriétés optiques différentes pour la construction des segments actifs non communs aux voies de résonateurs ou les influençant de manière différente.

4. Laser interférométrique à semi-conducteur conformément à la spécification 1, caractérisé par le fait que le segment central est produit sur un seul substrat monolithique en même temps que les segments actifs couplés avec lui.

5. Laser interférométrique à semi-conducteur conformément à la spécification 4, caractérisé par le fait que le segment central (2) comporte un séparateur de faisceau et une partie linéaire de segment.

6. Laser interférométrique à semi-conducteur conformément à la spécification 4 ou la spécification 5, caractérisé par le fait que le segment central comporte des parties laser actives et des parties laser passives.

7. Laser interférométrique à semi-conducteur conformément à la spécification 1, caractérisé par le fait que le segment central est formé par un système optique discret séparateur de faisceau - lentilles.

8. Laser interférométrique à semi-conducteur conformément à une des spécifications 1 à 3, caractérisé par le fait qu'un système passif de fibres optiques sert de segment central.

9. Procédé pour l'exploitation d'un laser à semi-conducteur conformément à une des spécifications 1 à 8, caractérisé par le fait qu'un courant est créé et traverse deux segments (3, 4) au moins du laser, l'un au moins de ces derniers appartenant exclusivement à une voie de résonateur, et que le rapport (I3/I4) des intensités des deux courants est modifié afin d'ajuster sur l'axe des longueurs d'ondes une position souhaitée du minimum absolu d'une courbe de pertes Mach-Zehnder (V) conditionnée par les différentes longueurs de voies optiques des résonateurs traversés par les courants.

10. Procédé conformément à la spécification 9, caractérisé par le fait qu'on varie le rapport des courants tout en maintenant constante l'intensité du courant total.

11. Procédé conformément à la spécification 9 ou 10, caractérisé par le fait qu'un courant supplémentaire est créé sur au moins un segment (1) commun aux deux voies de résonateurs.

12. Procédé conformément à la spécification 11, caractérisé par le fait qu'on varie le courant traversant le segment (1) commun aux deux voies de résonateurs pour commuter progressivement entre des gammes de longueurs d'ondes ou entre des longueurs d'ondes auparavant sélectionnées de ces gammes de longueurs d'ondes.

13. Procédé conformément aux spécifications 9 à 13, caractérisé par le fait que les longueurs des résonateurs sont au préalable ajustées de telle sorte que l'écart entre les minimums des courbes de pertes Mach-Zehnder soit approximativement égal à l'écart entre les modes de Fabry et Pérot, et que la sélection du mode de Fabry et Pérot souhaité se fait en réalisant la coïncidence entre le minimum d'une courbe de pertes Mach-Zehnder et le minimum de la courbe de pertes du matériau transparent constituant les segments actifs, ceci à la longueur d'onde du mode de Fabry et Pérot souhaité, par variation du rapport des courants traversant les segments actifs de résonateurs interférents et/ou variation du courant total du laser.
